# EUROPEAN PATENT APPLICATION

(11) **EP 1 580 600 A1**
(43) Date of publication of application: **28.09.2005**
(21) Application number: 03810633.2
(22) Date of filing: 06.11.2003
(51) Int. Cl.: G03F 7/039, H01L 21/027, C08F 16/02, C08F 16/24, C08F 8/02

(54) **RESIST COMPOSITION**

(30) Priority: 07.11.2002 JP 2002323825
(71) Applicant: ASAHI GLASS COMPANY LTD., Tokyo 100-8405 (JP)
(72) Inventor: KAWAGUCHI, Yasuhide Asahi Glass Company, Limited, Yokohama-shi, Kanagawa 221-8755 (JP); KANEKO, Isamu Asahi Glass Company, Limited, Yokohama-shi, Kanagawa 221-8755 (JP); TAKEBE, Yoko Asahi Glass Company, Limited, Yokohama-shi, Kanagawa 221-8755 (JP); OKADA, Shinji Asahi Glass Company, Limited, Yokohama-shi, Kanagawa 221-8755 (JP); YOKOKOJI, Osamu Asahi Glass Company, Limited, Yokohama-shi, Kanagawa 22 1-8755 (JP)
(74) Representative: Müller-Boré & Partner Patentanwälte
(86) International application number: PCT/JP2003/014158
(87) International publication number: WO 2004/042475

(57) **Abstract**

A resist composition which can easily form a resist pattern excellent in transparency for vacuum ultraviolet rays such as an F₂ excimer laser or the like and dry etching characteristics and further excellent in sensitivity, resolution, flatness, thermal resistance and the like, is provided.

The resist composition, **characterized by** comprising (A) a fluorine-containing polymer having an acidic group blocked with a blocking group containing a cycloalkyl group, an organic group having one or more of cycloalkyl groups, a bicycloalkyl group or the like, (B) an acid generating compound capable of generating an acid by irradiation with a light, and (C) an organic solvent.

## Description

### TECHNICAL FIELD

The present invention relates to a novel resist composition. More particularly, it relates to a chemical amplification type resist composition useful for fine processing employing far ultraviolet rays such as KrF or ArF excimer laser, or vacuum ultraviolet rays such as F₂ excimer laser.

### BACKGROUND ART

In recent years, along with the progress in fine circuit patterns in the process for producing semiconductor integrated circuits, a photoresist material having high resolution and high sensitivity is demanded. As the circuit patterns become fine, a short wavelength of a light source for an exposure apparatus becomes essential. In an application to lithography employing an excimer laser of 250 nm or shorter, a polyvinyl phenol type resin, an alicyclic acrylic type resin, a polynorbornene type resin (e.g., description of WO01/63362 or the like), a fluorinated resin (e.g., description of WO00/17712 or the like) or the like has, for example, been proposed, but satisfactory resolution, sensitivity and high dry etching resistance have not been obtained.

It is an object of the present invention to provide a resist composition which is a resist particularly employed for far ultraviolet rays such as KrF or ArF excimer laser, or vacuum ultraviolet rays such as F₂ excimer laser, and which is also excellent in resolution and dry etching resistance, as a chemical amplification type resist.

### DISCLOSURE OF THE INVENTION

The present invention is the following invention which has been made to solve the above-described problems.

Namely, the present invention is a resist composition which comprises (A) a fluoropolymer having an acidic group, a part of the acidic group being blocked with a blocking group represented by the formula (1), (B) an acid generating compound capable of generating an acid by irradiation with a light, and (C) an organic solvent;

-CHR¹-O-R² (1)

(wherein R¹ is a hydrogen atom or an alkyl group having a carbon number of at most 3, and R² is a cycloalkyl group which may have a substituent, a monovalent organic group having at least one said cycloalkyl group, a bridged cyclic saturated hydrocarbon having 2 to 4 rings which may have a substituent, or an organic group having said bridged cyclic saturated hydrocarbon).

### BEST MODE FOR CARRYING OUT THE INVENTION

A blocking group of the present invention is characterized in that it is easily detached by an acid, and it is not easily detached by an alkali. An appropriate blocking group for this condition is required to have a structure as the formula (1).

-CHR¹-O-R² (1)

R¹ represents a hydrogen atom or an alkyl group having a carbon number of at most 3, but it is particularly preferred to be a hydrogen atom or a methyl group. Further, in a case of employing as a chemical amplification type resist which is useful for fine processing employing vacuum ultraviolet rays such as F₂ excimer laser, R² is a cycloalkyl group which may have a substituent, a monovalent organic group having at least one said cycloalkyl group, a bridged cyclic saturated hydrocarbon having 2 to 4 rings which may have a substituent, or an organic group having said bridged cyclic saturated hydrocarbon, since they have an appropriate transparency to the ultraviolet rays.

A cycloalkyl group is preferably a C₅₋₈ cycloalkyl group, particularly preferably a cyclohexyl group. As the monovalent organic group, a C₁₋₃ alkyl group is preferred. The bridged cyclic saturated hydrocarbon having 2 to 4 rings represents a bicycloalkyl group, a tricycloalkyl group or a tetracycloalkyl group. As the bicycloalkyl group, a C₇₋₁₂ bicycloalkyl group is preferred, for example, a bicyclo-heptyl group such as bicyclo[2,2,1]heptyl group (a norbornyl group), a bicyclooctyl group, a bicyclodecyl group or the like may be mentioned. The norbornyl group is particularly preferred. As the tricycloalkyl group, a C₇₋₁₄ tricycloalkyl group is preferred. As the tetracycloalkyl group, a C₉₋₁₄ tetracycloalkyl group is preferred. As a substituent which may be bonded to these rings, it is not particularly limited as long as it is an inactive substituent. However, the substituents represented by the following R³ to R⁶ are preferred, and a number of substituent per ring is preferably from 1 to 5.

Further, it is preferred that R² has a structure represented by the formula (2), (3) or (4).

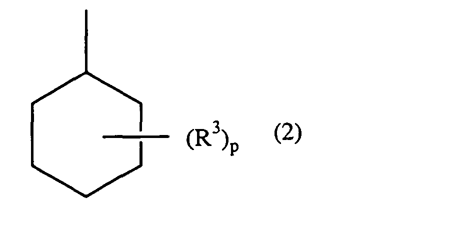

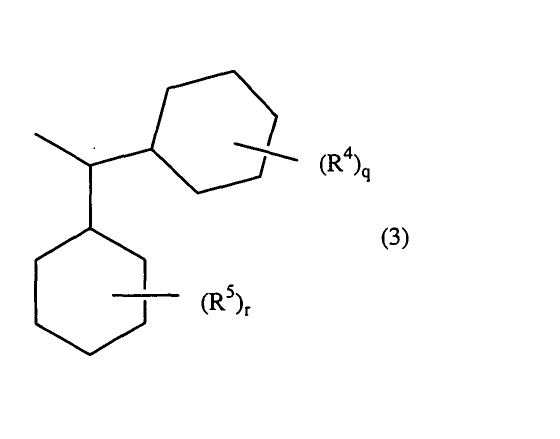

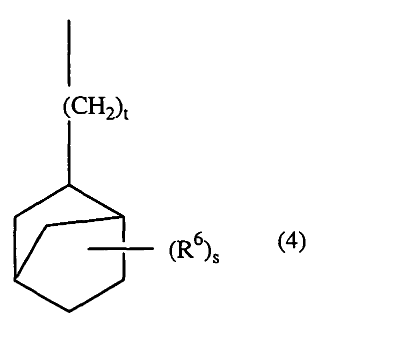

In the above formulae, each of R³, R⁴, R⁵ and R⁶ which are independent from each other, is a fluorine atom, an alkyl group having a carbon number of at most 3, a tert-butyl group, a cyclohexyl group, a cyclopentyl group or a fluoroalkyl group having a carbon number of at most 3; each of p, q, r and s which are independent from each other, is an integer of from 0 to 11; and t is 0 or 1. If p is an integer of at least 2, each R³ may be different. If q is an integer of at least 2, each R⁴ may be different. If r is an integer of at least 2, each R⁵ may be different. If s is an integer of at least 2, each R⁶ may be different.

Further, in the formula (2), R³ is a C₁₋₃ alkyl group, a tert-butyl group or a cyclohexyl group, and particularly preferably p is an integer of from 1 to 3. In the formula (3), it is particularly preferred when q and r are both 0, or each of q, r and s which are independent from each other, is an integer of from 1 to 3, and each of R⁴, R⁵ and R⁶ which are independent from each other, is a C₁₋₃ alkyl group.

Fluoropolymer (A) of the present invention has an acidic group, and a part of the acidic group is blocked by a blocking group represented by the formula (1). The term "Blocked" means that acidic hydrogen of an acidic group is substituted by a blocking group. Hereinafter, an acidic group which is blocked, is referred to as a blocked acidic group. Fluoropolymer (A) of the present invention is preferred to have an acidic group which is not blocked, and in use of such fluoropolymer (A), a solubility of a resist material can be controlled by controlling a proportion of an acidic group which is not blocked. The ratio of an acidic group blocked by a blocking group of the formula (1) in the fluoropolymer (A) (a ratio of an acidic group blocked by the blocking group of the formula (1) to the total acidic groups of a blocked acidic group and an acidic group which is not blocked) is preferably from 5 to 99 mol%, particularly from 10 to 90 mol%.

The fluoropolymer of the present invention has an acidic group, and is a polymer containing a fluorine atom bonded to a carbon atom on its main chain of the polymer. Among these, a ratio of a number of fluorine atoms to the total number of atoms is from 15% to 60%, and it is preferably a polymer having a fluorine atom on its main chain. Further, it is preferably a polymer having an aliphatic ring structure on its main chain.

In the present invention, the term "aliphatic ring structure" means a cyclic structure comprising only carbon atoms or a cyclic structure comprising carbon atoms and other atoms, and it is a ring structure without having a delocalized unsaturated double bond. An oxygen atom is preferred as the other atoms. A number of atoms constituting a ring is preferably from 4 to 8, particularly from 5 to 7.

In the present invention, the wording "having an aliphatic ring structure on its main chain" means that at least one carbon atom constituting the aliphatic ring is a carbon atom of the main chain. In a case where one of carbon atoms constituting the aliphatic ring is a carbon atom of the main chain by having two connecting bonds connected to a side chain, a bivalent group is bonded to the carbon atom of the main chain (the aliphatic ring is constituted by the carbon atom of the main chain and the bivalent group). In a case where at least two of carbon atoms constituting an aliphatic ring are carbon atoms of the main chain, a bivalent group is bonded to two different carbon atoms of the at least two carbon atoms of the main chain (when two carbon atoms of the main chain, to which a bivalent group is bonded, are adjacent to each other, the aliphatic ring is constituted by the two carbon atoms and the bivalent group, and when an additional carbon atom on its main chain exists between those two carbons of the main chain, to which a bivalent group is bonded, an aliphatic ring is constituted by at least those three carbon atoms of the main chain and the bivalent group).

A polymer having an aliphatic ring structure on its main chain is preferably a polymer having an aliphatic ring structure and a monomer unit prepared by polymerizing a compound having one polymerizable double bond formed by at least one carbon atom constituting an aliphatic ring, or a polymer having a monomer unit prepared by cyclopolymerizing a fluorinated diene.

A preferable example of a compound having at least one said polymerizable double bond may, for example, be norbornene or the like. As a specific polymer, a copolymer containing fluoroolefin and norbornene may be mentioned as a preferable example.

As the fluoropolymer having an acidic group in the present invention, it is particularly preferred to have a monomer unit obtained by cyclopolymerizing a fluorinated diene represented by the formula (5):

CF₂=CR⁸-Q-CR⁹=CH₂ (5)

(wherein each of R⁸ and R⁹ which are independent from each other, is a hydrogen atom, a fluorine atom, a methyl group or a trifluoromethyl group, and Q is a bivalent organic group represented by the formula (6)):

-R¹⁰-C(R¹²) (R¹³)-R¹¹- (6)

(wherein each of R¹⁰ and R¹¹ which are independent from each other, is a single bond, an oxygen atom, an alkylene group having at most 3 carbon atoms, which may have an etheric oxygen atom, or a fluoroalkylene group having at most 3 carbon atoms, which may have an etheric oxygen atom; R¹² is a hydrogen atom, a fluorine atom, an alkyl group having at most 3 carbon atoms or a fluoroalkyl group having at most 3 carbon atoms; and R¹³ is an acidic group, or a monovalent organic group having an acidic group).

It is considered that by cyclopolymerization of the fluorinated diene represented by the formula (5) (hereinafter referred to as "fluorinated diene (5)"), the following monomer units (a) to (c) will be formed. From the results of the spectroscopic analysis, etc., a cyclopolymerized polymer of the fluorinated diene (5) is considered to be a polymer having a structure containing at least one monomer unit selected from monomer unit (a), monomer unit (b) and monomer unit (c). Here, the main chain of this cyclopolymerized polymer is meant for a carbon chain constituted by carbon atoms which constitute polymerizable unsaturated bonds (four carbon atoms constituting polymerizable unsaturated double bonds in the case of the fluorinated diene (5)).

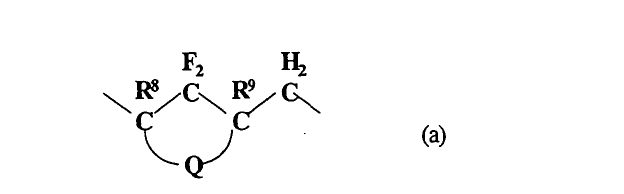

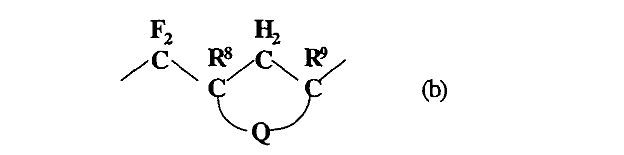

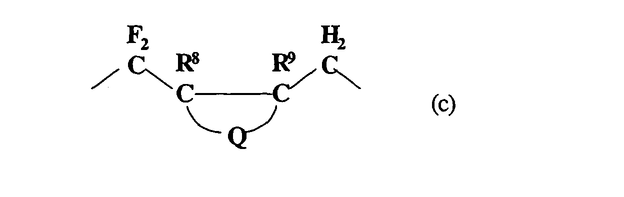

The alkylene group in R¹⁰ or R¹¹ of the fluorinated diene (5) is preferably (CH₂)ₘ, and the fluoroalkylene group is preferably (CF₂)ₙ (each of m and n is an integer of from 1 to 3). In a combination of R¹⁰ and R¹¹, it is preferred that both are alkylene groups or fluoroalkylene groups (in such case, m+n is preferably 2 or 3), or one of them is an alkylene group or a fluoroalkylene group, and the other is a single bond or an oxygen atom. An alkyl group for R¹² is preferably a methyl group, and a fluoroalkyl group for R¹² is preferably a trifluoromethyl group.

R¹³ in the case of a monovalent organic group, is preferably an organic group having at most 8 carbon atoms, and the moiety excluding the acidic group, is preferably a hydrocarbon group or a fluorohydrocarbon group. Particularly preferred is a C₂₋₆ alkyl group, a C₂₋₆ fluoroalkyl group or a C₇₋₉ phenylalkyl group, which has an acidic group. Specifically, the following groups may be mentioned as R¹³ (wherein k is an integer of from 1 to 6, and X is an acidic group).

- (CH₂) ₖ-X, - (CH₂) ₖC (CF₃) ₂-X,

-(CH₂)ₖC(CH₃)₂-X,

-(CH₂)ₖC(CF₃) (CH₃)-X,

-(CH₂)ₖCH(CH₃)-X, -(CH₂)ₖC₆H₄-X.

Compound of the following chemical formulae may be mentioned as preferred examples of the fluorinated diene (5) :

CF₂=CF (CF₂)ₐC(-Y) (CF₃) (CH2)_{b}CH=CH₂,

CF₂=CF (CF₂)ₐC (-Y) (CF₃) (CF₂)_{b}CH=CH₂,

CF₂=CF (CH₂) ₐC (-Y) (CF₃) (CH₂)_{b}CH=CH₂,

CF₂=CF (CH₂) ₐC (-Y) (CF₃) (CF₂)_{b}CH=CH₂,

CF₂=CF (CF₂) ₐC (-Y) (CF₃) (CF₂) _{b}C (CH₃) =CH₂,

CF₂=C(CF₃) (CF₂)ₐC(-Y) (CF₃) (CF₂) _{b}CH=CH₂,

CF₂=CF (CF₂) ₐCH (-Z) (CH₂) _{b}CH=CH₂.

In the above formulae, Y is X or -R¹³, and Z is -R¹³.

The most preferred fluorinated diene (5) is a compound of the following formula (7) or (8).

CF₂=CFCF₂C (-X) (CF₃) CH₂CH=CH₂ (7)

CF₂=CFCF₂CH (- (CH₂)ₖC (CF₃)₂-X) CH₂CH=CH₂ (8)

The acidic group in the present invention may, for example, be an acidic hydroxyl group, a carboxylic group or a sulfonic group, particularly preferably an acidic hydroxyl group and a carboxylic group, most preferably an acidic hydroxyl group. The acidic hydroxyl group is a hydroxyl group indicating acidity, and it may, for example, be a hydroxyl group bonded directly to a ring of an aryl group (a phenolic hydroxyl group), a hydroxyl group bonded to a carbon atom having a perfluoroalkyl group bonded thereto, or a hydroxyl group bonded to a tertiary carbon atom. Particularly preferred is a hydroxyl group bonded to a carbon atom having 1 or 2 perfluoroalkyl groups bonded thereto. A C₁₋₂ perfluoroalkyl group is preferred as the perfluoroalkyl group. In a case where the perfluoroalkyl group is a trifluoromethyl group, for example, a hydroxyl group in a bivalent group of the following formula (d-1) (i.e., a hydroxyl group in a hydroxytrifluoromethylmethylene group) or a hydroxyl group in a monovalent group of the following formula (d-2) or (d-3) (i.e., a hydroxyl group in a 1-hydroxy-1-trifluoromethyl-2,2,2-trifluoroethyl group or a 1-hydroxy-1-methyl-2,2,2-trifluoroethyl group) is preferred.

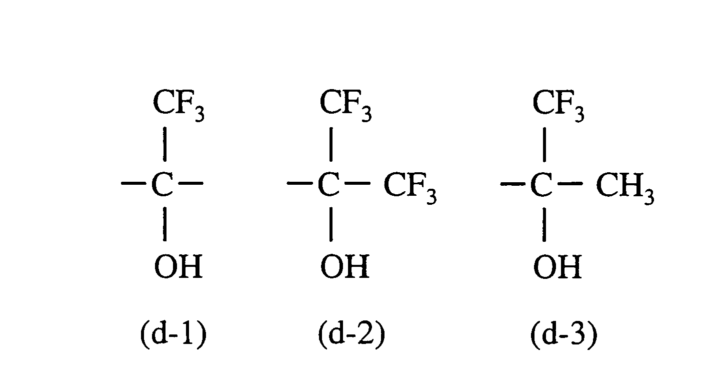

The fluoropolymer (A) of the present invention can simultaneously employ a blocking group represented by the formula (1) and a blocking group other than the blocking group represented by the formula (1) (hereinafter referred to as "other blocking group"). Hereinafter, an acidic group blocked by the blocking group represented by the formula (1) is described as "blocked acidic group (1)", or an acidic group blocked by other blocking group is described as "other blocked acidic group". The blocked ratio of the fluoropolymer (A) (i.e. the ratio of blocked acidic groups (1) and other blocked acidic groups to the total of the blocked acidic groups (1), other blocked acidic groups and non-blocked acidic groups) is preferably from 10 to 99 mol%, particularly preferably from 10 to 90 mol%. Further, within the blocked ratio, the ratio of the blocked acidic groups (1) (i.e. ratio of the blocked acidic groups (1) to the total of the blocked acidic groups (1) and other blocked acidic groups) is preferably from 5 to 90 mol%.

Here, in a case where an acidic group is a carboxylic group or a sulfonic group, other blocked acidic groups mean esteric blocked acidic groups in which an acidic hydrogen atom of said carboxylic acid or sulfonic acid is substituted by an alkyl group or the like. And in a case where an acidic group is an acidic hydroxyl group, other blocked acidic groups mean acetal, ketal, ester or ether type blocked acidic groups having a structure other than the structure of the formula (1), which are obtainable by substituting a hydrogen atom of the acidic hydroxyl group with an alkyl group, an alkoxycarbonyl group, an acyl group, a cyclic ether group or the like.

As the above-mentioned alkyl group, a C₁₋₆ alkyl group which may have a substituent (such as an aryl group or an alkoxy group), may be mentioned. Examples of such an alkyl group include an alkyl group having at most 6 carbon atoms (such as a tert-butyl group (t-C₄H₉)), an aryl group-substituted alkyl group having a total carbon number of from 7 to 20 (such as a benzyl group, a triphenylmethyl group, a p-methoxybenzyl group or a 3,4-dimethoxybenzyl group), and an alkoxyalkyl group having a total carbon number of at most 8 (such as a methoxymethyl group, a (2-methoxyethoxy)methyl group or a benzyloxymethyl group). A preferred alkoxycarbonyl group for substituting the hydrogen atom of the hydroxyl group, may, for example, be an alkoxycarbonyl group having the total carbon number of at most 8 such as a tert-butoxycarbonyl group (-COO(t-C₄H₉)). A preferred acyl group for substituting the hydrogen atom of the hydroxyl group, may be an acyl group having the total carbon number of at most 8, and it may, for example, be a pivaloyl group, a benzoyl group or an acetyl group. A preferred cyclic ether group for substituting the hydrogen atom of the hydroxyl group, may, for example, be a tetrahydropyranyl group (THP).

The acidic group of the fluoropolymer of the present invention may previously exist in a monomer for obtaining the fluoropolymer, and it may be a group capable of being converted to an acidic group in a monomer and may be converted to an acidic group after polymerization. Further, with regard to the blocked acidic group, it may be a monomer having a blocked acidic group obtained by reacting a compound (hereinafter sometimes referred to as "blocking agent") having a blocking group to an acidic group at the stage of a monomer, or after polymerization of a monomer having an acidic group or a group capable of being converted to an acidic group, it may be converted to a blocked acidic group by reacting a blocking agent to the acidic group or the group capable of being converted to an acidic group.

As the blocking agent having a blocking group represented by the formula (1), any one can be used as long as it is capable of substituting an acidic hydrogen atom, but a halide represented by the formula (9) may be mentioned as a preferable example.

J-CHR¹-O-R² (9)

Here, J represents a halogen atom, and it is particularly preferred to be a chlorine atom. With regard to R¹ and R², R¹ and R² are the same as defined in the formula (1).

Other blocked acidic groups are obtainable by reacting an acidic group such as a hydroxyl group, a carboxylic group or a sulfonic group with a compound (hereinafter sometimes referred to as "other blocking agents") having other blocking groups. These other blocking agents may, for example, be a halogenated methyl alkyl ether, an alkyl halide, an acid chloride, an acid anhydride, a chlorocarbonic acid ester, a dialkyldicarbonate (such as di-tert-butyldicarbonate) or 3,4-dihydro-2H-pyran.

Examples of other blocking agents useful for blocking an acidic hydroxyl group of the present invention are disclosed in "Handbook of Reagents for Organic Synthesis: Activating Agents and Protecting Groups", edited by A.J. Pearson and W.R. Roush, and published by John Wiley & Sons (1999).

Preferable examples of blocked acidic hydroxyl groups blocked by other blocking groups, include -O(t-C₄H₉), -OCH₂OCH₃, -OCH₂OC₂H₅, -CO₂(t-C₄H₉), -OCH(CH₃)OC₂H₅ or a 2-tetrahydropyranyloxy group.

The molecular weight of the fluoropolymer (A) of the present invention is not particularly limited so long as it can be uniformly dissolved in an organic solvent which will be described hereinafter and it can be uniformly coated on a substrate. However, usually, its number average molecular weight as calculated in terms of polystyrene is suitably from 1,000 to 100,000, preferably from 2,000 to 20,000. If the number average molecular weight is 1,000 or more, a better resist pattern, a sufficient film remaining rate after development, or a better dimensional stability during the heat treatment of the pattern, is obtainable. If the number average molecular weight is 100,000 or less, the coating property of the composition is likely to be better, or the sufficient developability may be retained.

A polymerization initiating source is not particularly limited so long as it makes polymerization reaction proceed radically. For example, it may be a radical-generating agent, light or ionizing radiation. Particularly preferred is a radical-generating agent, and a peroxide, an azo compound or a persulfate may, for example, be mentioned. A polymerization method is also not particularly limited, and so-called bulk polymerization in which monomers are subjected to polymerization as they are, solution polymerization which is carried out in an organic solvent such as a fluorohydrocarbon, a chlorohydrocarbon, a fluorinated chlorohydrocarbon, an alcohol, a hydrocarbon or other organic solvents, capable of dissolving monomers, suspension polymerization which is carried out in an aqueous medium in the absence or presence of a suitable organic solvent, or emulsion polymerization which is carried out by adding an emulsifier to an aqueous medium, may, for example, be mentioned.

An acid-generating compound (B) in the present invention generates an acid under irradiation with light. By the acid thus generated, a blocked acidic group which exists in the fluoropolymer (A), is cleaved (deblocked). As this result, the exposed portions of a resist film will become readily soluble by an alkaline developer, whereby a positive resist pattern will be formed by the alkaline developer. As such an acid-generating compound (B) which generates an acid under irradiation with light, it is possible to employ an acid-generating compound which is commonly used for a chemical amplification type resist material. Namely, an onium salt, a halogenated compound, a diazoketone compound, a sulfone compound or a sulfonic acid compound, may, for example, be mentioned. The following may be mentioned as specific examples of such an acid-generating compound (B).

The onium salt may, for example, be an iodonium salt, a sulfonium salt, a phosphonium salt, a diazonium salt or a pyridinium salt. Specific examples of a preferred onium salt include diphenyliodonium triflate, diphenyliodoniumpyrenesulfonate, diphenyliodoniumdodecylbenzenesulfonate, bis(4-tert-butylphenyl)iodonium triflate, bis(4-tert-butylphenyl)iodoniumdodecylbenzenesulfonate, triphenylsufonium triflate, triphenylsulfonium hexafluoroantimonate, 1-(naphthylacetomethyl)thioranium triflate, cyclohexylmethyl(2-oxocyclohexyl)sulfonium triflate, dicyclohexyl(2-oxocyclohexyl)sulfonium triflate, dimethyl(4-hydroxynaphthyl)sulfonium tosylate, dimethyl(4-hydroxynaphthyl)sulfoniumdodecyl-benzenesulfonate, dimethyl(4-hydroxynaphthyl)sulfoniumnaphthalenesulfonate, triphenylsulfoniumcamphorsulfonate, or (4-hydroxyphenyl)benzylmethylsulfoniumtoluenesulfonate.

The halogenated compound may, for example, be a haloalkyl group-containing hydrocarbon compound or a haloalkyl group-containing heterocyclic compound. Specifically, it may, for example, be (trichloromethyl)-s-triazine derivatives such as phenyl-bis(trichloromethyl)-s-triazine, methoxyphenyl-bis(trichloromethyl)-s-triazine or naphthyl-bis(trichloromethyl)-s-triazine, or 1,1-bis(4-chlorophenyl)-2,2,2-trichloroethane.

The sulfone compound may, for example, be β-ketosulfone, β-sufonylsulfone or an α-diazo compound of such a compound. Specifically, it may, for example, be 4-trisphenacylsulfone, mesitylphenacylsulfone, or bis(phenylsulfonyl)methane. The sulfonic compound may, for example, be an alkylsulfonic acid ester, an alkylsulfonic acid imide, a haloalkylsulfonic acid ester, an arylsulfonic acid ester or an iminosulfonate. Specifically, it may, for example, be benzointosylate or 1,8-naphthalenedicarboxylic acid imide triflate. In the present invention, such an acid-generating compound (B) may be used alone or in combination as a mixture of two or more of them.

The organic solvent (C) of the present invention is not particularly limited so long as it is capable of dissolving both components (A) and (B). It may, for example, be alcohols such as methyl alcohol or ethyl alcohol, ketones such as acetone, methyl isobutyl ketone or cyclohexanone, acetates such as ethyl acetate or butyl acetate, aromatic hydrocarbons such as toluene or xylene, glycol monoalkyl ethers such as propylene glycol monomethyl ether or propylene glycol monoethyl ether, or glycol monoalkyl ether esters such as propylene glycol monomethyl ether acetate or carbitol acetate.

The proportion of the respective components in the resist composition of the present invention are usually such that the acid-generating compound (B) is from 0.1 to 20 parts by mass and the organic solvent (C) is from 50 to 2,000 parts by mass, per 100 parts by mass of the fluoropolymer (A). Preferably, the acid-generating compound (B) is from 0.1 to 10 parts by mass and the organic solvent (C) is from 100 to 1,000 parts by mass, per 100 parts by mass of the fluoropolymer (A).

If the amount of the acid-generating compound (B) is at least 0.1 part by mass, a better sensitivity and developability can be provided, and if it is at most 10 parts by mass, a sufficient transparency to radiation is retained, whereby more accurate resist pattern will be obtained.

In the resist composition of the present invention, an acid-cleavable additive to improve a pattern contrast, a surfactant to improve a coating property, a nitrogen-containing basic compound to adjust an acid-generating pattern, an adhesion-assisting agent to improve an adhesion to a substrate or a storage stabilizer to enhance a storage stability of the composition, may be optionally incorporated. Further, the resist composition of the present invention is preferably employed in such a manner that the respective components are uniformly mixed, followed by filtration by means of a filter of from 0.03 to 0.45 µm.

The resist composition of the present invention is coated on a substrate such as a silicone wafer, followed by drying to form a resist film. As the coating method, spin coating, cast coating or roll coating may, for example, be employed. The formed resist film will be irradiated with light via a mask having a pattern drawn thereon, followed by development treatment to form the pattern.

The light beams for the irradiation may, for example, be ultraviolet rays such as g-line having a wavelength of 436 nm or i-line having a wavelength of 365 nm, or far ultraviolet rays or vacuum ultraviolet rays, such as KrF excimer laser having a wavelength of 248 nm, ArF excimer laser having a wavelength of 193 nm or F₂ excimer laser having a wavelength of 157 nm. The resist composition of the present invention is a resist composition useful particularly for an application where ultraviolet rays having a wavelength of at most 250 nm, especially ultraviolet rays having a wavelength of at most 200 nm (such as ArF excimer laser or F₂ excimer laser), are used as the light source.

As the development treatment solution, various alkali aqueous solutions are employed. As such an alkali material, sodium hydroxide, potassium hydroxide, ammonium hydroxide, tetramethylammonium hydroxide or triethylamine may, for example, be mentioned.

### EXAMPLES

Now, the present invention will be described in further detail with reference to Examples. However, it should be understood that the present invention is by no means restricted by such specific Examples. Here, THF represents tetrahydrofuran, R113 represents trichlorotrifluoroethane (organic solvent), and TFE represents tetrafluoroethylene.

### [Preparation Example of chloromethyl(2-cyclohexylcyclohexyl)ether]

### (PREPARATION EXAMPLE 1)

Preparation was carried out on the basis of journals, A. Warshawsky, A. Deshe, R. Gutman, British Polymer Journal, 16 (1984) 234, and J. Polym. Sci, Polym. Chem. Ed., 23(6) (1985) 1839.

A 500 ml reactor made of glass was substituted by nitrogen, 46.6 g of 2-cyclohexylcyclohexanol and 200 ml of dehydrated chloroform were charged therein, and the resultant solution was stirred by a stirrer, and then 7.70 g of paraformaldehyde was added therein at the time of complete dissolution. Next, the reactor was cooled to 0 to 5°C by ice bath, and hydrogen chloride was introduced into the solution by a bubbler. When a suspension of the solution caused by paraformaldehyde became clear and the solution became transparent, the introduction of hydrogen chloride was stopped. The lower phase was separately isolated, followed by drying by adding 28.3 g of anhydrous calcium chloride powder. Thereafter, 48.0 g of chloromethyl(2-cyclohexylcyclohexyl)ether was obtained (the purity according to ¹H NMR was 87%) after distillation of the solvent.

Hereinafter, the data of ¹H NMR is shown: ¹H NMR (399.8 MHz, solvent: CDCl₃, standard: tetramethylsilane) δ (ppm): 0.84-2.23 (m, 20H), 3.54-4.20 (m, 1H (exo-, endo-form mixed)), 5.55-5.62 (m, 2H).

### [Preparation Example of chloromethyl fenchyl ether]

### (PREPARATION EXAMPLE 2)

45.9 g of chloromethyl fenchyl ether was obtained in the same manner as in Preparation Example 1 except that 39.5 g of fenchyl alcohol was used instead of using 46.6 g of 2-cyclohexylcyclohexanol in Preparation Example 1. The yield was 88%, and the purity according to ¹H NMR was 90%. Hereinafter, the data of ¹H NMR is shown:
¹H NMR (399.8 MHz, solvent: CDCl₃, standard:
tetramethylsilane) δ (ppm): 0.87-1.68 (m, 16H), 3.32 (s, 1H (exo-, endo-form mixed)), 5.48-5.50 (m, 2H).

### [Preparation Example of chloromethyl(2-norbornanemethyl)ether]

### (PREPARATION EXAMPLE 3)

40.6 g of chloromethyl(2-norbornanemethyl)ether was obtained in the same manner as in Preparation Example 1 except that 32.3 g of 2-norbornanemethanol was used instead of using 46.6 g of 2-cyclohexylcyclohexanol in Preparation Example 1. The yield was 90%, and the purity according to ¹H NMR was 90%. Hereinafter, the data of ¹H NMR is shown:
¹H NMR (399.8 MHz, solvent: CDCl₃, standard:
tetramethylsilane) δ (ppm): 0.64-2.25 (m, 11H), 3.34-3.67 (m, 2H), 5.50-5.52 (m, 2H).

### [Preparation Example of chloromethyl(4-tert-butylcyclohexyl)ether]

### (PREPARATION EXAMPLE 4)

37.9 g of chloromethyl(4-tert-butylcyclohexyl)ether was obtained in the same manner as in Preparation Example 1 except that 40.0 g of 4-tert-butylcyclohexanol was used instead of using 46.6 g of 2-cyclohexylcyclohexanol in Preparation Example 1. The yield was 68%, and the purity according to ¹H NMR was 90%. Hereinafter, the data of ¹H NMR is shown:
¹H NMR (399.8 MHz, solvent: CDCl₃, standard:
tetramethylsilane) δ (ppm): 0.85 (s, 9H), 0.98-2.11 (m, 9H), 3.60-4.02 (m, 1H(exo-, endo-form mixed)), 5.56 (s, 2H).

### [Preparation Example of chloromethyl(dicyclohexylmethyl)ether]

### (PREPARATION EXAMPLE 5)

49.9 g of chloromethyl(dicyclohexylmethyl)ether was obtained in the same manner as in Preparation Example 1 except that 50.3 g of dicyclohexylmethanol was used instead of using 46.6 g of 2-cyclohexylcyclohexanol in Preparation Example 1. The yield was 79%, and the purity according to ¹H NMR was 86%. Hereinafter, the data of ¹H NMR is shown:
¹H NMR (399.8 MHz, solvent: CDCl₃, standard:
tetramethylsilane) δ (ppm): 1.40-14.4 (m, 20H), 1.45-2.06 (m, 2H), 2.81 (d, 1H), 5.46 (s, 2H).

### [Preparation Example of chloromethylneopentyl ether]

### (PREPARATION EXAMPLE 6)

27.1 g of chloromethylneopentyl ether was obtained in the same manner as in Preparation Example 1 except that 22.6 g of neopentyl alcohol was used instead of using 46.6 g of 2-cyclohexylcyclohexanol in Preparation Example 1. The yield was 77%, and the purity according to ¹H NMR was 66%. Hereinafter, the data of ¹H NMR is shown:
¹H NMR (399.8 MHz, solvent: CDCl₃, standard:
tetramethylsilane) δ (ppm): 0.92 (s, 9H), 3.34 (s, 2H), 5.59 (s, 2H).

### [Preparation Example of fluorinated diene (1)]

### (PREPARATION EXAMPLE 7)

Into a 2 L reactor made of glass, 108 g of CF₂ClCFClCF₂C(O)CF₃ and 500 ml of dehydrated THF were charged and cooled to 0°C. A diluted solution having 200 ml of a 2M THF solution of CH₂=CHCH₂MgCl further diluted with 200 ml of dehydrated THF, was dropwise added thereto in a nitrogen atmosphere over a period of about 5.5 hours. After completion of the dropwise addition, the mixture was stirred at 0°C for 30 minutes and at room temperature for 17 hours, whereupon 200 ml of 2N hydrochloric acid was dropwise added. 200 ml of water and 300 ml of diethyl ether were added for liquid separation, and a diethyl ether layer was obtained as an organic layer. The organic layer was dried over magnesium sulfate, followed by filtration to obtain a crude liquid. The crude liquid was concentrated by an evaporator, followed by distillation under reduced pressure to obtain 85 g of CF₂ClCFClCF₂C(CF₃) (OH)CH₂CH=CH₂ (60 to 66°C/0.7 kPa).

Then, into a 500 ml reactor made of glass, 81 g of zinc and 170 ml of dioxane were charged, and activation of zinc was carried out by iodine. The reactor was heated to 100°C, and a solution prepared by diluting 84 g of CF₂ClCFClCF₂C(CF₃) (OH)CH₂CH=CH₂ synthesized as described above, with 50 ml of dioxane, was dropwise added thereto over a period of 1.5 hours. After completion of the dropwise addition, the mixture was stirred at 100°C for 40 hours. The reaction solution was filtered and washed with a small amount of dioxane. The filtrate was distilled under reduced pressure to obtain 30 g of CF₂=CFCF₂C(CF₃) (OH)CH₂CH=CH₂ (36 to 37°C/1 kPa). Hereinafter, the data of ¹H NMR and ¹⁹F NMR are shown:
¹H NMR (399.8 MHz, solvent: CDCl₃, standard:
tetramethylsilane) δ (ppm): 2.74 (d, J=7.3, 2H), 3.54 (boad s, 1H), 5.34 (m, 2H), 5.86 (m, 1H).
¹⁹F NMR (376. 2 MHz, solvent: CDCl₃, standard: CFCl₃) δ (ppm): -75.7 (m, 3F), -92.2 (m, 1F), -106.57 (m, 1F), -112.6 (m, 2F), -183.5 (m, 1F).

### (PREPARATION EXAMPLE 8)

Into a 10 L reactor made of glass, 758 g of CF₂ClCFClCF₂C(O)CF₃ and 4.5 L of dehydrated THF were charged and cooled to 0°C. 1.4 L of a 2M THF solution of CH₂=CHCH₂MgCl, was dropwise added thereto in a nitrogen atmosphere over a period of about 10.5 hours. After completion of the dropwise addition, the mixture was stirred at 0°C for 30 minutes and at room temperature for 12 hours, whereupon 350 g of chloromethylmethyl ether was dropwise added. The mixture was further stirred at room temperature for 92 hours. 1.5 L of water was.added, followed by liquid separation. The organic layer was concentrated by an evaporator to obtain a crude liquid, and the crude liquid was washed twice with 1.5 L of water. Then, it was distilled under reduced pressure to obtain 677 g of CF₂ClCFClCF₂C(CF₃) (OCH₂OCH₃) CH₂CH=CH₂ (53 to 55°C/0.17 kPa).

Then, into a 3 L reactor made of glass, 577 g of zinc and 1.3 L of dioxane were charged, and activation of zinc was carried out by iodine. Then, the reactor was heated to 100°C, and 677 g of CF₂ClCFClCF₂C(CF₃) (OCH₂OCH₃)CH₂CH=CH₂ synthesized as described above, was dropwise added thereto over a period of 2 hours. After completion of the dropwise addition, the mixture was stirred at 100°C for 47 hours. The reaction solution was filtered and washed with a small amount of dioxane. To the filtrate, 2.5 L of water and 1.5 L of ether were added, followed by liquid separation. The organic layer was dried over anhydrous magnesium sulfate, followed by filtration to obtain a crude liquid. The crude liquid was concentrated by an evaporator, followed by distillation under reduced pressure to obtain 177 g of CF₂=CFCF₂C(CF₃) (OCH₂OCH₃)CH₂CH=CH₂ (43 to 45°C/0.6 kPa). Hereinafter, the data of ¹H NMR and ¹⁹F NMR are shown:
¹H NMR (399.8 MHz, solvent: CDCl₃, standard:
tetramethylsilane) δ (ppm): 3.16 (broad, 2H), 3.44 (s, 3H), 4.95 (m, 2H), 5.22 (m, 2H), 5.92 (m, 1H).
¹⁹F NMR (376. 2 MHz, solvent: CDCl₃, standard: CFCl₃) δ (ppm): -72.5 (m, 3F), -92.9 (m, 1F), -106.8 (m, 1F), -109.7 (m, 2F), -183.0 (m, 1F).

### [Preparation Example of fluoropolymer (A)]

### (PREPARATION EXAMPLE 9)

7.50 g of 1,1,2,3,3-pentafluoro-4-trifluoromethyl-4-hydroxy-1,6-heptadiene [CF₂=CFCF₂C(CF₃) (OH)CH₂CH=CH₂], 3.66 g of 1,4-dioxane and 16.6 g of methyl acetate were charged into a pressure resistant reactor made of glass having an internal capacity of 30 mL. Then, 0.22 g of perfluorobenzoyl peroxide was added as a polymerization initiator. The interior of the system was freeze-deaerated, and polymerization was carried out for 18 hours in a constant temperature shaking vessel (70°C). After the polymerization, the reaction solution was dropwise added into hexane to reprecipitate a polymer, followed by vacuum drying at 150°C for 15 hours. As a result, 5.40 g of a white powdery non-crystalline polymer having a fluorinated cyclic monomer unit on its main chain was obtained. The molecular weight of the polymer was measured by GPC (THF solvent) whereby as calculated in terms of polystyrene, the number average molecular weight (Mn) was 7,600, and the weight average molecular weight (Mw) was 15,000, whereby Mw/Mn=1.99. The glass transition point measured by differential scanning calorimetry (DSC) was 152°C.

### (PREPARATION EXAMPLE 10)

4.82 g of 1,1,2,3,3-pentafluoro-4-trifluoromethyl-4-hydroxy-1,6-heptadiene [CF₂=CFCF₂C(CF₃) (OH)CH₂CH=CH₂], 1.00 g of 1,1,2,3,3-pentafluoro-4-trifluoromethyl-4-methoxymethyloxy-1,6-heptadiene (CF₂=CFCF₂C(CF₃) (OCH₂OCH₃)CH₂CH=CH₂], 0.78 g of 1,4-dioxane and 15.4 g of methyl acetate were charged into a pressure resistant reactor made of glass having an internal capacity of 30 mL. Then, 0.088 g of perfluorobenzoyl peroxide was added as a polymerization initiator. The interior of the system was freeze-deaerated, and then, polymerization was carried out for 18 hours in a constant temperature shaking vessel (70°C). After the polymerization, the reaction solution was dropwise added into hexane to reprecipitate a polymer, followed by vacuum drying at 150°C for 15 hours. As a result, 5.16 g of a white powdery non-crystalline polymer having a fluorinated cyclic monomer unit in its main chain was obtained. The molecular weight of the polymer was measured by GPC (THF solvent), whereby as calculated in terms of polystyrene, the number average molecular weight (Mn) was 12,800, and the weight average molecular weight (Mw) was 31,000, whereby Mw/Mn=2.42. The glass transition point measured by differential scanning calorimetry (DSC) was 140°C.

The polymer composition calculated by ¹⁹F NMR and ¹H NMR measurement, was such that a monomer unit composed of 1,1,2,3,3-pentafluoro-4-trifluoromethyl-4-hydroxy-1,6-heptadiene/a monomer unit composed of 1,1,2,3,3-pentafluoro-4-trifluoromethyl-4-methoxymethyloxy-1,6-heptadiene=85.0/15.0 mol%.

### (PREPARATION EXAMPLE 11)

5.04 g of 1,1,2,3,3-pentafluoro-4-trifluoromethyl-4-hydroxy-1, 6-heptadiene [CF₂=CFCF₂C(CF₃) (OH)CH₂CH=CH₂], 2.51 g of 1,1,2,3,3-pentafluoro-4-trifluoromethyl-4-methoxymethyloxy-1,6-heptadiene [CF₂=CFCF₂C (CF₃) (OCH₂OCH₃) CH₂CH=CH₂], 3.52 g of 1, 4-dioxane and 16.9 g of methyl acetate were charged into a pressure resistant reactor made of glass having an internal capacity of 30 mL. Then, 0.224 g of perfluorobenzoyl peroxide was added as a polymerization initiator. The interior of the system was freeze-deaerated, and then, polymerization was carried out for 18 hours in a constant temperature shaking vessel (70°C). After the polymerization, the reaction solution was dropwise added into hexane to reprecipitate a polymer, followed by vacuum drying at 150°C for 15 hours. As a result, 5.29 g of a white powdery non-crystalline polymer (hereinafter referred to as polymer 1A) having a fluorinated cyclic monomer unit on its main chain was obtained. The molecular weight of polymer 1A was measured by GPC (THF solvent), whereby as calculated in terms of polystyrene, the number average molecular weight (Mn) was 12,900, and the weight average molecular weight (Mw) was 7,300, whereby Mw/Mn=1.77. The glass transition point measured by differential scanning calorimetry (DSC) was 140°C.

The polymer composition calculated by ¹⁹F NMR and ¹H NMR measurement, was such that a monomer unit composed of 1,1,2,3,3-pentafluoro-4-trifluoromethyl-4-hydroxy-1,6-heptadiene/a monomer unit composed of 1,1,2,3,3-pentafluoro-4-trifluoromethyl-4-methoxymethyloxy-1,6-heptadiene=70/30 mol%.

### (PREPARATION EXAMPLE 12)

6.43 g of 1,1,2,3,3-pentafluoro-4-trifluoromethyl-4-hydroxy-1,6-heptadiene [CF₂=CFCF₂C(CF₃) (OH)CH₂CH=CH₂], 0.18 g of tert-butyl methacrylate, 0.93 g of 1,4-dioxane and 20.4 g of methyl acetate were charged into a pressure resistant reactor made of glass having an internal capacity of 30 mL. Then, 0.112 g of perfluorobenzoyl peroxide was added as a polymerization initiator. The interior of the system was freeze-deaerated, and then, polymerization was carried out for 18 hours in a constant temperature shaking vessel (70°C). After the polymerization, the reaction solution was dropwise added into hexane to reprecipitate a polymer, followed by vacuum drying at 150°C for 15 hours. As a result, 5.28 g of a white powdery non-crystalline polymer having a monomer unit composed of a fluorinated cyclic monomer unit and tert-butyl methacrylate in its main chain, was obtained. The molecular weight of polymer was measured by GPC (THF solvent), whereby as calculated in terms of polystyrene, the number average molecular weight (Mn) was 8,300, and the weight average molecular weight (Mw) was 16,800, whereby Mw/Mn=2.01. The glass transition point measured by differential scanning calorimetry (DSC) was 162°C.

The polymer composition calculated by ¹⁹F NMR and ¹H NMR measurement, was such that a monomer unit composed of 1,1,2,3,3-pentafluoro-4-trifluoromethyl-4-hydroxy-1,6-heptadiene/a monomer unit composed of tert-butyl methacrylate=95/5 mol%.

### (PREPARATION EXAMPLE 13)

4.5 g of 1,1,2,3,3-pentafluoro-4-trifluoromethyl-4-hydroxy-1, 6-heptadiene [CF₂=CFCF₂C(CF₃) (OH)CH₂CH=CH₂], 1,72 g of 1,1,2,3,3-pentafluoro-4-trifluoromethyl-4-methoxymethyloxy-1,6-heptadiene [CF₂=CFCF₂C(CF₃) (OCH₂OCH₃)CH₂CH=CH₂], 0.166 g of tert-butyl methacrylate, 0.69 g of 1,4-dioxane and 16.58 g of methyl acetate were charged into a pressure resistant reactor made of glass having an internal capacity of 30 mL. Then, 0.095 g of perfluorobenzoyl peroxide was added as a polymerization initiator. The interior of the system was freeze-deaerated, and then, polymerization was carried out for 18 hours in a constant temperature shaking vessel (70°C). After the polymerization, the reaction solution was dropwise added into hexane to reprecipitate a polymer, followed by vacuum drying at 150°C for 15 hours. As a result, 5.40 g of a white powdery non-crystalline polymer (hereinafter referred to as polymer 2A) having a monomer unit composed of a fluorinated cyclic monomer unit and tert-butyl methacrylate in its main chain, was obtained. The molecular weight of polymer 2A was measured by GPC (THF solvent), whereby as calculated in terms of polystyrene, the number average molecular weight (Mn) was 10,000, and the weight average molecular weight (Mw) was 31,000, whereby Mw/Mn=3.10. The glass transition point measured by differential scanning calorimetry (DSC) was 150°C.

The polymer composition calculated by ¹⁹F NMR and ¹H NMR measurement, was such that a monomer unit composed of 1,1,2,3,3-pentafluoro-4-trifluoromethyl-4-hydroxy-1,6-heptadiene/a monomer unit composed of 1,1,2,3,3-pentafluoro-4-trifluoromethyl-4-methoxymethyloxy-1,6-heptadiene/a monomer unit composed of tert-butyl methacrylate=72/23/5 mol%.

### (PREPARATION EXAMPLE 14)

150 g of R113 was charged into a deaerated autoclave made of stainless steel having an internal capacity of 0.2 liter with a stirrer, and 14.4 g of TFE, 1.504 g of norbornene and 33.28 g of 1,1,1-trifluoro-2-trifluoromethyl-4-penten-2-ol (hereinafter referred to as AF2) were introduced therein. Thereafter, it was heated up to 55°C, polymerization was initiated by injecting 8 ml of R113 solution of 1.67 g of tert-butyl peroxypivalate. The pressure was 0.69 MPa at the point of reaching a temperature of 55°C. After 10 hours of reaction, the pressure was lowered to 0.62 MPa. After cooling the autoclave to room temperature, a polymer solution was taken out after purging an unreacted gas. The polymer solution thus obtained was put in methanol to precipitate, followed by vacuum drying at 50°C after washing, and 6.3 g of fluoropolymer was obtained. The molecular weight of the polymer as calculated in terms of polystyrene, measured by GPC (THF solvent), was such that the number average molecular weight (Mn) was 2,400, and the weight average molecular weight (Mw) was 3,400, whereby Mw/Mn=1.42.

The polymer composition calculated by ¹⁹F NMR and ¹H NMR measurement, was such that TFE unit/norbornene unit/AF2 unit=35/20/45 mol%.

### (PREPARATION EXAMPLE 15)

5.00 g of the polymer obtained in Preparation Example 9 and 25 mL of methanol were charged into a 200 mL round flask and stirred by a magnetic stirrer. After dissolving the polymer, a methanol solution of sodium hydroxide (wherein 0.31 g of sodium hydroxide and 7.65 g of methanol were previously added and dissolved) was added and thoroughly stirred overnight at room temperature. After distillation of the solvent, 200 mL of dehydrated THF and 1.95 g of chloromethyl 2-cyclohexylcyclohexyl ether obtained in Preparation Example 1 were added therein and stirred intensely. After stirring for 3 days at room temperature, the solvent was distilled off. The residue was dissolved in 100 mL of diethyl ether, and 200 mL of pure water was added for liquid separation in order to remove an aqueous component. After distilling the solvent from the organic layer, the residue was dissolved in 20 mL of acetone, and it was dropwise added into hexane to reprecipitate a polymer. The polymer thus obtained was vacuum dried at 130°C for 15 hours, and 4.20 g of a white powdery non-crystalline polymer (hereinafter referred to as polymer 3A) was obtained.

The protection rate (the ratio of blocked acidic groups to the total acidic groups (%)) calculated by ¹H NMR measurement was 29%.

### (PREPARATION EXAMPLE 16)

4.20 g of a white powdery non-crystalline polymer (hereinafter referred to as polymer 4A) was obtained in the same manner as in Preparation Example 15 except that 1.58 g of chloromethylfenchyl ether obtained in Preparation Example 2 was used instead of using 1.95 g of chloromethyl(2-cyclohexylcyclohexyl)ether in Preparation Example 15.

The protection rate (the ratio of blocked acidic groups to the total acidic groups (%)) calculated by ¹H NMR measurement was 32%.

### (PREPARATION EXAMPLE 17)

4.30 g of a white powdery non-crystalline polymer (hereinafter referred to as polymer 5A) was obtained in the same manner as in Preparation Example 15 except that 2.17 g of chloromethyl(2-norbornanemethyl)ether obtained in Preparation Example 3 was used instead of using 1.95 g of chloromethyl(2-cyclohexylcyclohexyl)ether in Preparation Example 15.

The protection rate (the ratio of blocked acidic groups to the total acidic groups (%)) calculated by ¹H NMR measurement was 33%.

### (PREPARATION EXAMPLE 18)

4.00 g of a white powdery non-crystalline polymer (hereinafter referred to as polymer 6A) was obtained in the same manner as in Preparation Example 15 except that 1.69 g of chloromethyl(4-tert-butylcyclohexyl)ether obtained in Preparation Example 4 was used instead of using 1.95 g of chloromethyl(2-cyclohexylcyclohexyl)ether in Preparation Example 15.

The protection rate (the ratio of blocked acidic groups to the total acidic groups (%)) calculated by ¹H NMR measurement was 32%.

### (PREPARATION EXAMPLE 19)

4.10 g of a white powdery non-crystalline polymer (hereinafter referred to as polymer 7A) was obtained in the same manner as in Preparation Example 15 except that 1.60 g of chloromenthyl ether was used instead of using 1.95 g of chloromethyl(2-cyclohexylcyclohexyl)ether in Preparation Example 15.

The protection rate (the ratio of blocked acidic groups to the total acidic groups (%)) calculated by ¹H NMR measurement was 34%.

### (PREPARATION EXAMPLE 20)

4.40 g of a white powdery non-crystalline polymer (hereinafter referred to as polymer 8A) was obtained in the same manner as in Preparation Example 15 except that 1.91 g of chloromethyl(dicyclohexylmethyl)ether obtained in Preparation Example 5 was used instead of using 1.95 g of chloromethyl(2-cyclohexylcyclohexyl)ether in Preparation Example 15.

The protection rate (the ratio of blocked acidic groups to the total acidic groups (%)) calculated by ¹H NMR measurement was 27%.

### (PREPARATION EXAMPLE 21)

4.30 g of a white powdery non-crystalline polymer (hereinafter referred to as polymer 9A) was obtained in the same manner as in Preparation Example 15, except that the polymer obtained in Preparation Example 10 was used instead of using the polymer obtained in Preparation Example 9, that the amount of sodium hydroxide solution was changed so as to have 0.16 g of sodium hydroxide added and dissolved in 3.83 g of methanol, and that amount of chloromethyl(2-cyclohexylcyclohexyl)ether was changed to 0.98 g.

The protection rate (the ratio of blocked acidic groups to the total acidic groups (%)) calculated by ¹H NMR measurement was 29% (breakdown: 14% (protective group of Preparation Example 1), 15% (MOM)).

### (PREPARATION EXAMPLE 22)

4.00 g of a white powdery non-crystalline polymer (hereinafter referred to as polymer 10A) was obtained in the same manner as in Preparation Example 15, except that the polymer obtained in Preparation Example 12 was used instead of using the polymer obtained in Preparation Example 9, and that the amount of sodium hydroxide solution in Preparation Example 15 was changed so as to have 0.21 g of sodium hydroxide added and dissolved in 5.10 g of methanol.

The protection rate (the ratio of blocked acidic groups to the total acidic groups (%)) calculated by ¹H NMR measurement was 25% (breakdown: 20% (protective group of Preparation Example 1), 5% (tert-butyl group of tert-butyl methacrylate)).

### (PREPARATION EXAMPLE 23)

5.00 g of the polymer obtained in Preparation Example 14 and 25 mL of methanol were charged into a 200 mL round flask and stirred by a magnetic stirrer. After dissolving the polymer thoroughly, a sodium hydroxide methanol solution (0.31 g of sodium hydroxide was previously dissolved in 7.65 g of methanol) was added and stirred at room temperature for overnight. After distilling the solvent, 200 mL of dehydrated THF and 1.95 g of a chloride obtained in Preparation Example 1 were added therein and stirred intensely. After a period of time, the solution gradually became clouded. After stirring at room temperature for several days, the solvent was distilled off. Thereafter, the residue was dissolved in 100 mL of diethyl ether and 200 mL of pure water was added for liquid separation. After distilling the solvent from the organic layer, the residue was dissolved in 20 mL of acetone, and then it was dropwise added into hexane to reprecipitate a polymer. Thereafter, it was vacuum-dried at 130°C for 15 hours. As a result, 4.20 g of a white powdery non-crystalline polymer (hereinafter referred to as polymer 11A) was obtained.

The protection rate (the ratio of blocked acidic groups to the total acidic groups (%)) calculated by ¹H NMR measurement was 29%.

### (PREPARATION EXAMPLE 24)

5.0 g of the polymer obtained in Preparation Example 9 and 25 mL of methanol were charged into a 200 mL round flask and stirred by a magnetic stirrer. After dissolving the polymer thoroughly, a sodium hydroxide methanol solution (0.31 g of sodium hydroxide was previously dissolved in 7.65 g of methanol) was added and stirred at room temperature for overnight. After distilling the solvent, 200 mL of dehydrated THF and 1.71 g of a chloride obtained in Preparation Example 6 were added therein and stirred intensely. After a period of time, the solution gradually became clouded. After stirring at room temperature for several days, the solvent was distilled off. The residue was dissolved in 100 mL of diethyl ether and 200 mL of pure water was added for liquid separation. After distilling the solvent from the organic layer, the residue was dissolved in 20 mL of acetone, and it was dropwise added into hexane to reprecipitate a polymer. And it was vacuum-dried at 130°C for 15 hours. As a result, 4.40 g of a white powdery non-crystalline polymer (hereinafter referred to as polymer 12A) was obtained.

The protection rate (the ratio of blocked acidic groups to the total acidic groups (%)) calculated by ¹H NMR measurement was 35%.

### (PREPARATION EXAMPLE 25)

5.00 g of the polymer obtained in Preparation Example 14 and 25 mL of methanol were charged into a 200 mL round flask and stirred by a magnetic stirrer. After dissolving the polymer thoroughly, a sodium hydroxide methanol solution (0.31 g of sodium hydroxide was previously dissolved in 7.65 g of methanol) was added and stirred at room temperature for overnight. After distilling the solvent, 200 mL of dehydrated THF and 1.95 g of chloromethylmethyl ether were added therein and stirred intensely. After a period of time, the solution gradually became clouded. After stirring at room temperature for several days, the solvent was distilled off. The residue was dissolved in 100 mL of diethyl ether, and 200 mL of pure water was added for liquid separation. After distilling the solvent from the organic layer, the residue was dissolved in 20 mL of acetone, and it was dropwise added in hexane to reprecipitate a polymer. And it was vacuum-dried at 130°C for 15 hours. As a result, 4.20 g of a white powdery non-crystalline polymer (hereinafter referred to as polymer 13A) was obtained.

The protection rate (the ratio of blocked acidic groups to the total acidic groups (%)) calculated by ¹H NMR measurement was 29%.

### (EXAMPLE 1)

1 g of polymer 3A obtained in Preparation Example 15 and 0.05 g of trimethylsulfonium triflate were dissolved in 10 g of propylene glycol monomethyl ether acetate, followed by filtration by means of a PTFE filter having a pore diameter of 0.2 µm to produce a resist composition.

The above resist composition was spin-coated on a silicon substrate treated with hexamethyldisilazane, followed by heat treatment at 80°C for 2 minutes to form a resist film having a thickness of 0.3 µm. In an exposure test apparatus flushed with nitrogen, the substrate having the above resist film formed, was placed, and a mask having a pattern drawn by chromium on a quartz plate, was put thereon in close contact therewith. ArF excimer laser beams were irradiated through the mask, whereupon, after exposure at 100°C for 2 minutes, baking was carried out. Development was carried out at 23°C for 3 minutes with a tetramethylammonium hydroxide aqueous solution (2.38 mass%), followed by washing with pure water for 1 minute. The light transmittance of the resist film, the development test and the etching resistance results are shown in Table 1.

### EXAMPLES 2 to 9, COMPARATIVE EXAMPLES 1 to 4

Resist films were formed in the same manner as in Example 1 except that the polymer 3A in Example 1 was changed to respective polymers indicated in Table 1, and the development tests and the etching resistances were evaluated. The light transmittances of the resist films, the results of the development tests and the etching resistances are shown in Table 1.

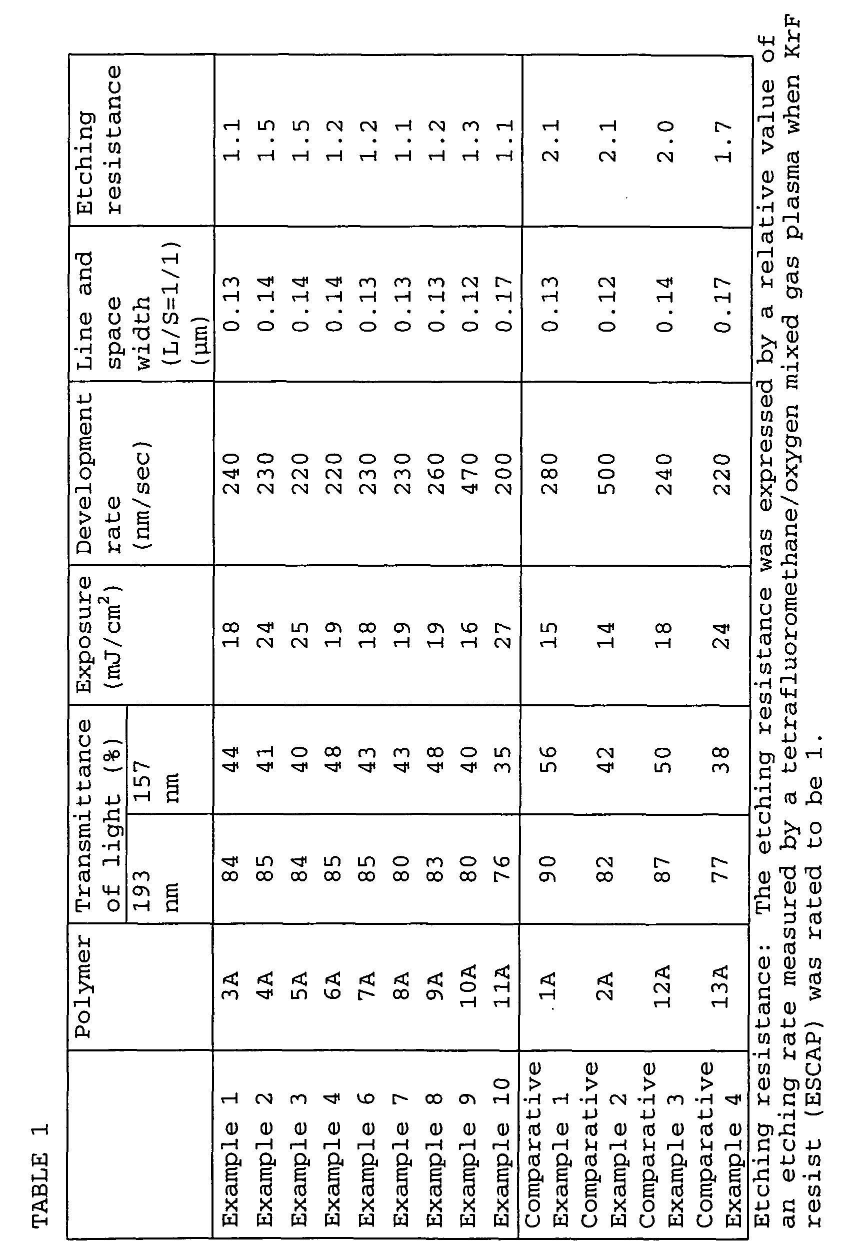

### INDUSTRIAL APPLICABILITY

The resist composition of the present invention can be used as a chemical amplification type resist, and can easily form a resist pattern which is particularly excellent in transparency for vacuum ultraviolet rays such as an F₂ excimer laser or far ultraviolet rays such as KrF or ArF excimer laser and in dry etching characteristics, and further excellent in sensitivity, resolution, flatness, thermal resistance and the like.

## Claims

1. A resist composition which comprises (A) a fluoropolymer having an acidic group, a part of the acidic group being blocked with a blocking group represented by the formula (1), (B) an acid generating compound capable of generating an acid by irradiation with a light, and (C) an organic solvent;
-CHR¹-O-R² (1)
(wherein R¹ is a hydrogen atom or an alkyl group having a carbon number of at most 3, and R² is a cycloalkyl group which may have a substituent, a monovalent organic group having at least one said cycloalkyl group, a bridged cyclic saturated hydrocarbon having 2 to 4 rings which may have a substituent, or an organic group having said bridged cyclic saturated hydrocarbon).

2. The resist composition according to Claim 1, wherein R² is a group represented by the formula (2), (3), or (4) : 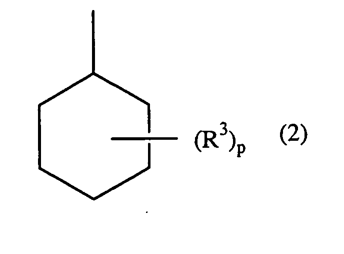 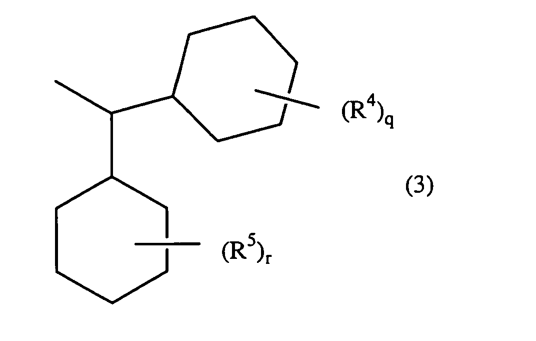 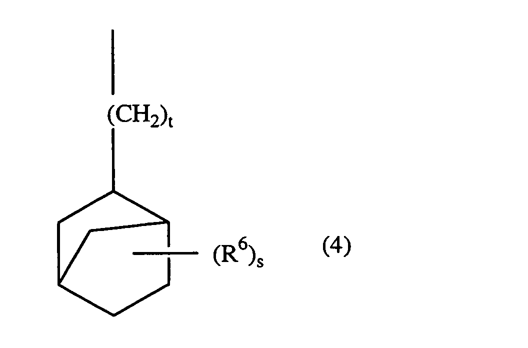 (wherein each of R³, R⁴, R⁵ and R⁶ which are independent from each other, is a fluorine atom, an alkyl group having a carbon number of at most 3, a tert-butyl group, a cyclohexyl group, a cyclopentyl group or a fluoroalkyl group having a carbon number of at most 3; each of p, q, r and s which are independent from each other, is an integer of from 0 to 11; t is 0 or 1; if p has an integer of at least 2, each R³ may be different; if q has an integer of at least 2, each R⁴ may be different; if r has an integer of at least 2, each R⁵ may be different; and if s has an integer of at least 2, each R⁶ may be different).

3. The resist composition according to Claim 1 or 2, wherein the acidic group is an acidic hydroxyl group.

4. The resist composition according to any one of Claims 1 to 3, wherein the fluoropolymer having an acidic group is a polymer having an aliphatic ring structure in the main chain.

5. The resist composition according to any one of Claims 1 to 4, wherein the fluoropolymer having an acidic group has a structure having a monomer unit cyclopolymerized with a fluorinated diene represented by the formula (5),
CF₂=CR⁸-Q-CR⁹=CH₂ (5)
(wherein each of R⁸ and R⁹ which are independent from each other, is a hydrogen atom, a fluorine atom, a methyl group or a trifluoromethyl group, and Q is a bivalent organic group represented by the formula (6)),
-R¹⁰-C(R¹²) (R¹³)-R¹¹- (6)
(wherein each of R¹⁰ and R¹¹ which are independent from each other, is a single bond, an oxygen atom, an alkylene group having a carbon number of at most 3, which may have an etheric oxygen atom, or a fluoroalkylene group having a carbon number of at most 3, which may have an etheric oxygen atom; R¹² is a hydrogen atom, a fluorine atom, an alkyl group having a carbon number of at most 3, or a fluoroalkyl group having a carbon number of at most 3; and R¹³ is an acidic group, or a monovalent organic group having an acidic group).

6. The resist composition according to any one of Claims 1 to 5, wherein a part of the acidic group in the fluoropolymer is additionally blocked by a blocking group other than the structure represented by the formula (1).
